(19) Europäisches Patentamt
European Patent Office
Office européen des brevets

(11) **EP 2 555 324 A2**

(12) **EUROPEAN PATENT APPLICATION**

(43) Date of publication:
**06.02.2013 Bulletin 2013/06**

(51) Int Cl.:
*H01Q 3/24* (2006.01)     *H01Q 21/06* (2006.01)

(21) Application number: **12425132.3**

(22) Date of filing: **30.07.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.08.2011 IT RM20110411**

(71) Applicant: **Selex Sistemi Integrati S.p.A.**
**00131 Roma (RM) (IT)**

(72) Inventors:
• **Buonanno, Aniello**
**00131 Roma(RM) (IT)**

• **D'Urso, Michele**
**00131 Roma(RM) (IT)**
• **Falessi, Carlo**
**00131 Roma(RM) (IT)**
• **Labate, Maria Grazia**
**00131 Roma(RM) (IT)**

(74) Representative: **Perronace, Andrea et al**
**Barzano & Zanardo Roma S.p.A.**
**Via Piemonte 26**
**00187 Roma (IT)**

(54) **Method for synthesizing an electro-magnetic pulse in the time domain, and appraratus for irradiation of such an electro-magnetic pulse**

(57) The present invention concerns a method for the formation of a desired electromagnetic pulse by using an array of antennae in the time domain, and a relevant modular apparatus for the transmission of electromagnetic pulses, wherein each module is provided with means adapted to realize a programmed synchronization of the array.

Fig. 2

EP 2 555 324 A2

**Description**

The present invention concerns a method for synthesizing an electro-magnetic pulse in the time domain, and apparatus for the irradiation of such an electro-magnetic pulse.

More in detail, the present invention concerns a method for the formation of a desired electromagnetic pulse by using an array of antennae in the time domain, and a relevant modular apparatus for the transmission of electromagnetic pulses, wherein each module is provided with means adapted to realize a programmed synchronization of the array.

**1. Array in the time domain**

The classic arrays are arrays operating in the frequency domain (phased arrays), wherein each single antenna is excited by an narrowband signal composed by a superposition of the modulating signal and the carrier signal, to the end of irradiating the at a desired frequency (usually a high frequency).

The concept of array operating in the transient regime is a very different concept, which recalls quite different concepts and a formulation that is, so to say, "reciprocal". The use of the concept of transient regime introduces indeed the necessity of operating in the time domain, instead of operating in the frequency domain. Whilst the latter indeed describes a stationary phenomenon, i.e. a regime or steady-state, the arrays in time domain, also called timed arrays, are exactly based on shortest duration phenomena, generated by signals that are therefore single pulses, of shortest duration, wherein it is thus not possible to achieve a steady state situation.

Based on the foregoing, it is therefore possible to state that a timed array is the counterparty of a phased array, wherein each element is excited by a wideband signal instead of narrowband signal. In particular, the signal fed to the antenna consists of a pulse without carrier signal (this being a further difference with respect to the phased arrays), and the role played in the phased arrays by the wavelength of the carrier is now played by the so-called spatial length of the new pulse, *cT,* wherein *c* is the light speed and *T* is the duration at half amplitude of the irradiated pulse. As it happens for such a parameter, also the other "conventional" parameters in the frequency domain must be revised and redefined. Moreover, it would be clearer in the following that some parameters which are well-defined in frequency domain, such as for example the power density, will have no reason to exist anymore and this gives way to new definitions and reference parameters.

Notwithstanding the substantial differences on the formulation and with respect to reference parameters, the passage from frequency to time occurs by a simple application of the Fourier transform. It is therefore possible, for example, to carry out the passage from the electrical field irradiated in an area in the free space far away from an antenna, as defined in the frequency domain as:

$$\vec{E}_T(\omega, r, \theta, \varphi) = \zeta \frac{j\omega}{4\pi c} I(\omega) \vec{H}(\omega, \theta, \varphi) e^{-j\frac{\omega}{c}r} \qquad (1)$$

wherein:

- *I* = antenna input current;
- *H* = effective height of the antenna;
- *k* = wave number;
- *c* = light speed
- $\omega$ = angular frequency = $2\pi f = kc$
- $\zeta$: intrinsic impedance of the vacuum;
- $\theta$ and $\varphi$: angles individuating the irradiation direction;

Implementing the Fourier transform and thus obtaining the corresponding in the time domain:

$$\vec{e}_T(\theta, \varphi, t^*) = \zeta \frac{1}{4\pi rc} i(t^*) \otimes \frac{\partial \vec{h}(\theta, \varphi, t^*)}{\partial t^*} \qquad (2)$$

Wherein $t^* = t - \dfrac{r}{c}$.

Starting from this concept, it is possible to redefine the formulation, however considering that some formulas and parameters of the frequency domain must be revised, such for example those containing the spectral angular frequency $\omega$, since in the transient regime such an angular frequency must be defined on the whole signal band without considering the single frequency.

One as a similar case in the definition of the diagram of an antenna [1]. It is defined as the ratio between the power densities irradiated along a generic direction and the direction of the maximum, both ones depending on, besides angles individuating the direction, $\omega$ and $r$ (con $r \to \infty$). Such an equation holds in a purely sinusoidal functioning regime, since the parameter $\omega$ appearing in the equation has already been determined. To the end of overcoming the situation, it is possible to make reference to the irradiated energy density, instead of the power density, performing therefore integration of the whole duration of the pulse. In such a way, it is possible to define the (normalized) irradiation diagram as the ratio between the two energy densities, in a generic direction and in the direction of the maximum respectively.

It is important to note, as above mentioned, that this is one of the possible modes to redefine the radiation diagram in the time domain. The formulation describing the array behavior in the time domain appears to be not univocal and well-established. This gives the opportunity to introduce new formulas, definition of new parameters and the possibility to contribute to a "settlement" of such a concept, very little explored as yet (at least with respect to the phased arrays).

As example of introduction of new parameters, it is possible to cite the similarity factor describing the change of the waveform of the irradiated pulse as a function of the observation direction. It occurs indeed that the pulse exiting an array of antennae is the summation of the pulses exiting the single radiating elements and that, in the case of scanning, by the introduction of suitable time shift equal for all the pulses transmitted in succession from the single radiating elements, one has a widening of the same pulse which therefore is distorted.

A change in the formulation presupposes a change of the basic concepts of the functioning of the "new" array of antennae. Such a change implies to refuse the validity, in the time domain, of principles very well known in the frequency domain, such as for example the antenna reciprocity principle, which implies the equality of the radiation diagrams in reception and in transmission. In the time domain, such a reciprocity is not valid any longer, owing to the fact that the transient response of an antenna is proportional to the time derivative of the transient response in reception of the same antenna.

The behavior in the transient regime has a consequence also in terms of characteristics of the single components. If one considers the antennae, indeed, having to transmit pulses, they are not supposed in resonance, rather they must guarantee a low distortion of the pulse in the interest band and an adaptation with the feed line to the end of having a single travelling wave and a TEM mode (electrical and magnetic fields in the plane transversal to the propagation direction).

Document US 6,061,034 A describes a system able to irradiate high-voltage electromagnetic pulses. The system is constituted by: a high-voltage generator, a power modulator, a solid-state photoconductive switch, a stacked Blumlein and a UWB antenna. The power modulator is the component utilized to the end of modulating the power provided by the voltage generator into a signal having certain characteristics. Such a signal is then enabled or disabled by the use of the photoconductive switch which allows to divide the modulated signal into bursts of pulses. Thereafter, to the only end of amplifying the value of the voltage of the modulated signal, a stage of stacked Blumlein is introduced. In the document, no reference is made to a synthesis method for the determination of the desired modulation neither for the single channel nor for the case of an array. Moreover, the modulation is performed by means of the power modulator device which is the only component responsible of the generated signal form. The switch is intended in its classical function of enabler/disabler. The Blumlein in the stacked configuration is utilized to the only end of amplifying the signal fed to the antenna whose electromagnetic characteristics are never taken into account, which certainly influence the characteristics of the irradiated pulse. It is to be observed that in the document reference is always made to the architecture of a single channel, assuming that the extension to an array is simply the collection of more identical channels and without providing further information on the control of the whole array.

The article of Jon S.H. Schoenberg et al.: "Ultra-Wideband Source Using Gallium Arsenide Photoconductive semiconductor Switches", IEEE TRANSACTION ON PLASMA SCIENCE, IEEE SERVICE CENTER,

PISCATAWAY; NJ US, vol. 25, no. 2, 1 April 1997 (1997-04-01), XP011044808, ISSN: 0093-3813 describes a UWB pulses generator based on a GaAs photoconductive diode. It is to be noted that in the document reference is always made to the architecture of a single channel, citing the possibility of extension to the case of an array without defining how this would be realized. Moreover, a synthesis method for the determination of the desired modulation is not considered.

The article of J-C Diot el al.: "A Novel Antenna for Transient Applications in the Frequency Band 300 MHz - 3 GHz: The Valentine Antenna", IEEE TRANSACTION ON ANTANNAS AND PROPAGATION, IEEE SERVICE CENTER, PISCATAWAY, NJ, US, vol. 55. No. 3, 1 March 2007 (2007-03-01), pages 987-990, XP011172628, ISSS: 0018-926X, DOI: 10.1109/TAP.2007.891867 describes the design and realization of a UWB antenna. In order to analyze the radiation characteristics of the radiating element, a commercial waveforms generator has been considered. In the document, no reference is made to an architecture able to generate UWB waveforms (in input to the antenna itself).

It is object of the present invention to provide a method and system for the formation of desired waveforms, by suitable pulses controlled in the time domain, in particular to produce an overvoltage in semiconductor devices.

It is subject matter of the present invention a method for the determination of the parameters of electro-magnetic pulses to be sent to a transmission modules array of the type timed array having directions of extension x and/or y corresponding to the traditional Cartesian coordinate, each comprising at least a switch with opening time $t_{open}$, closing time $t_{close}$ and permanence time T of the switch in the close position, and relevant variability ranges, a UWB antenna with effective height $h(\theta,\varphi)$, an electric power generator, in order to irradiate altogether from said array a pre-defined electro-magnetic pulse defined by the following pulse parameters:

- beam width of the pre-defined pulse for every direction $\theta$, $\varphi$ of irradiation;
- bandwidth of the pre-defined pulse $\Delta f \in [f_{min}, f_{max}]$;
- scanning region as defined by the variation of the angles $\theta$, $\varphi$, $\Delta\theta \in [\theta_{min}, \theta_{max}]$, $\Delta\varphi \in [\varphi_{min}, \varphi_{max}]$;

wherein the pulses to be sent to the various modules have delays $\Delta\tau_x$ e $\Delta\tau_y$ in the two directions x and y,

The method being **characterised in that**:

- a numerical model is utilized which describes the different elements of each module of the modules array, as a function of varying parameters $\Delta\tau_x$, $\Delta\tau_y$, **T**, $t_{open}$, $t_{close}$, which are vectors whose components correspond to the various modules of the system, the numerical model providing the total transfer function $g(\Delta\tau_x, \Delta\tau_y, \mathbf{T}, t_{open}, t_{close})$ of said modules array,
- said transfer function is inserted into the following functional:

$$\Phi = \left\| g(\Delta\boldsymbol{\tau}_x, \Delta\boldsymbol{\tau}_y, \mathbf{T}, \mathbf{t}_{open}, \mathbf{t}_{close}) - G_0 \right\|^2$$

wherein $G_0$ is an objective function relevant to said pre-determined electro-magnetic pulse, said functional being minimized by an optimization algorithm, to determine the values of the delays $\Delta\tau_x$, $\Delta\tau_y$ and the values T, $t_{open}$, $t_{close}$ for each module and each irradiation direction $\theta,\varphi$.

It is known that the UWB antenna should have a time dispersion as small as possible.

Preferably according to the invention, once said values $\Delta\tau_x$, $\Delta\tau_y$, **T**, $t_{open}$, $t_{close}$ are obtained, a sensibility analysis is performed to the end of verifying the acceptable jitter values for each single module of said modules array.

Preferably according to the invention, each utilized module comprises at least a modified Blumlein PFN, comprising two transmission lines and a resistance in series between the two transmission lines and wherein:

- said at least a switch is at least a photoconductive switch comprising a generator of laser pulses of duration T, with rise time $t_{rise}$ and fall time $t_{fall}$;
- the resistance (R) is constituted or replaced by a UWB antenna;
- the two transmission lines presents respective lengths $L^1_{tx}$ e $L^2_{tx}$;

$L^2_{tx}$;

The functional to be minimized being:

$$\Phi = \left\| g(\Delta\boldsymbol{\tau}_x, \Delta\boldsymbol{\tau}_y, \mathbf{T}, \mathbf{t}_{rise}, \mathbf{t}_{fall}, \mathbf{L}^1_{tx}, \mathbf{L}^2_{tx}) - G_0 \right\|^2$$

Wherein $\mathbf{L}^1_{tx}$, $\mathbf{L}^2_{tx}$, $\mathbf{t}_{rise}$, $\mathbf{t}_{fall}$ are vectors whose components correspond to the various modules of the system and the parameters $\mathbf{t}_{rise}$ and $\mathbf{t}_{fall}$ are connected respectively to the parameters $\mathbf{t}_{close}$ and $\mathbf{t}_{open}$ by a functional relation.

This functional dependency on the lengths of the transmission line holds even in the case o fuse of systems different from the Blumlein, but still presenting transmission lines.

Preferably according to the invention, between both input and output parameters a priority scale is set, which is introduced by a weight vector.

Preferably according to the invention, said modified Blumlein comprises a further resistance in the place of the open circuit of the classical Blumlein, and in that the function *g* depends also on the value of said further resistance, whose value is therefore optimised.

It is further subject matter of the present invention a method for irradiating an electro-magnetic pulse by an irradiation modules array, each module comprising at least a switch, a UWB antenna, a power generator, **characterised in that** it executes the following steps:

- calculating:

  • time delays between pulses to be fed to each antenna of each module of the modules array;
  • duration T, opening time $t_{open}$ and closing time $t_{close}$ of said at least a switch for each module;
  according to the method of any claim 1 to 5;

- generating the single pulses within each module according to a time sequence corresponding to the calculated time delays; and
- sending said pulses to the corresponding UWB antenna.

It is further subject matter of the present invention an apparatus for the irradiation of a pre-determined electro-magnetic pulse having pre-defined pulse parameters by a transmission modules array of the type timed array having two directions of extension x and/or y, each module irradiating a module pulse according to a pre-defined time sequence between the modules, wherein each transmission module of said modules array comprises at least a Blumlein PFN, comprising two transmission lines, a resistance and at least a switch, and at least a power modulator, and wherein:

- said at least a switch is at least a photo-conductive switch comprising a generator of laser pulses of duration T, with rise time $t_{rise}$ and fall time $t_{fall}$;
- the resistance (R) is constituted or replaced by a UWB antenna;
- said two transmission lines of the Blumlein PFN and said UWB antenna are adapted so as to approximate a TEM mode;

the apparatus being characterized in that:

- the Blumlein PFN is modified in such a way that the two transmission lines present respective lengths $L^1_{tx}$ and $L^2_{tx}$ which can be independently determined;
- said at least a power modulator is constituted by the same modified Blumlein PFN, said at least a switch, and an electronic unit for controlling said pre-determined sequence module pulses,

said electronic unit for controlling possessing the values of said pulse parameters for each module and for each single irradiation direction, as calculated by using the method according to an aspect of the invention.

Preferably according to the invention, said UWB antenna has an input impedance that is substantially real and constant within the frequencies of the apparatus transmission bandwidth.

Preferably according to the invention, said antenna is chosen so as to guarantee a smooth transition between the transmission line and the antenna on one side, and the free space on the other side.

The invention will be now described by way of illustration but not by way of limitation, making particular reference to the Fig.s of the annexed drawings, wherein:

Fig. 1 shows a block diagram of the system according to an aspect of the invention.
Fig. 2 shows the architecture of an aspect of the system according to the invention.
Fig. 3 shows the diagram of a classical PFN Blumlein.
Fig. 4 shows a generic pulse exiting the PFN Blumlein of the module according to Fig. 3.
Fig. 5 shows a diagram of a Valentine antenna as realized by a simulator ("computer simulation technology").
Fig. 6 shows a first choice in the beamforming method for broadside (on the left) and scanning (on the right) according to an aspect of the invention.
Fig. 7 shows a second choice in the beamforming method for broadside (on the left) and scanning (on the right), according to an aspect of the invention.
Fig. 8 shows a third choice in the beamforming method for broadside (on the left) and scanning (on the right), according to an aspect of the invention.

Fig. 9 shows a general flowchart diagram of the method according to an aspect of the invention.

Fig. 10 shows a general block diagram of the method according to an aspect of the invention.

Fig. 11 shows a block diagram of the genres system considered for the synthesis algorithm, according to an aspect of the invention.

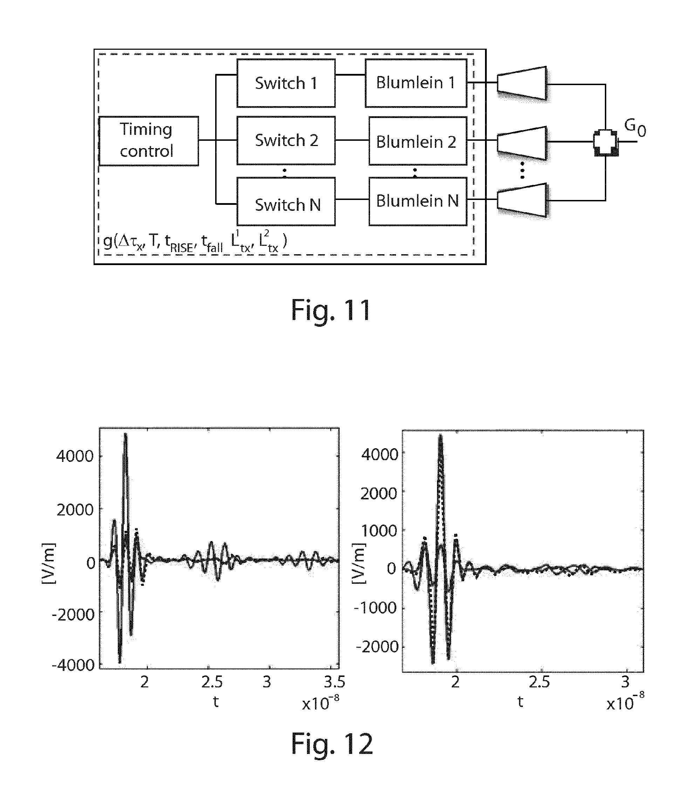

Fig. 12 shows signals irradiated by a 3x3 planar array; the continuous line traces represent the signal the aggregated by the array the case wherein $\Delta\tau_x$ = **[0,0,0]ns**, $\Delta\tau_y$ = **[0,0,0]ns.** The dashed line traces represent the signals irradiated by an array whose time delays between array modules are $\Delta\tau_y$ = **[0,0,0] ns and** $\Delta\tau_x$ = **[0,0.5,1] ns**, corresponding to the azimuth direction of 30°. Two ideal probes placed at broadside (a) and in scanning direction (b) has been considered, to the end of measuring the signal arriving along the two directions. One can note that the signal as measured by the probe placed at broadside is strong in the case wherein the delays between array modules are $\Delta\tau_x$ = **[0,0,0]ns**, $\Delta\tau_y$= **[0,0,0]ns** (which are exactly those needed for irradiating at broadside) and weak instead in the case wherein the delays are $\Delta\tau_y$ = **[0,0,0]ns** and $\Delta\tau_x$ = **[0,0.5,1]ns**; analogous case for the probe placed in the scanning direction, at which a strong signal arrives when the array has a time delay between pulses equal to $\Delta\tau_y$ = **[0,0,0]ns** and $\Delta\tau_x$ = **[0,0.5,1]ns** and vice versa when the array irradiates at broadside;

Fig. 13 shows an example of how the parameters $\Delta\tau_x$, $\Delta\tau_y$ influence much the form of the pulse irradiated by the considered array. In the example, one can see that by suitably combining the output pulses by choosing $\Delta\tau_x$, $\Delta\tau_y$, it is possible to markedly modify the time characteristics of the total irradiated signal, for example the duration or equivalently the band.

Fig. 14 shows the output of the transfer function, as numerical implemented in Matlab, wherein all the parameters are fixed (line impedance, switch characteristics, etc) and the transmission lines lengths $L^1_{tx}$, $L^2_{tx}$ are made varying: in (a) curves for many different parameters values are given, in (b) only for some of them, so as to make the graphs more legible.

Fig. 15 shows a block diagram of the system considered for the hybrid procedure according to an aspect of the invention.

Fig. 16 shows in (a) the current flowing in the photoconductive switch as a function of the laser $t_{rise}$ (keeping fixed $t_{fall}$ and the duration); in (b) the current flowing in the photoconductive switch as a function of the duration (by fixing $t_{rise}$ and $t_{fall}$);

Fig. 17 shows the values of the resistors as obtained as a function of the parameters of the laser pulses, according to an aspect of the invention.

Fig. 18 shows impulses obtained at the output of the Blumlein, according to an aspect of the invention.

Fig. 19 shows the comparison between the desired (normalized) waveform (cross symbol) and as obtained by the synthesis (square symbol).

## 2. Requirements for the system according to an aspect of the invention

The system according to the invention is a system able to provoke the multifunction and/or to damage remotely any standard electronic apparatus, which is not suitably screened, within a certain radius. This occurs by the radiation of very short duration pulses, but having a high peak power. Such highest power pulses are able to produce an overvoltage of thousands of Volt, such to inhibit the functioning of semiconductor devices.

Having as objective the generation of very shows pulses but with high content in terms of peak power, it is simple to understand that fundamental requirements for the system according to an aspect of the invention are represented by a strong limitation of the leakages in the feed network, a lowest possible power dispersion so as to convey all the energy in a limited area of the space, a structure most possibly light and compact, with the constraint not to exceed the air electric strength.

## 3. Timing of the system according to an aspect of the invention

To the end of fulfilling the above mentioned requirements, it is needed both to work on the architecture of the system and the single devices composing it, and to introduce algorithms that, taking into account the particular characteristics of the time domain, are able to synthesize the optimal waveform of the irradiated pulse, in the above defined terms, acting on the different steps affecting the generation of the same pulse.

This translates into an optimal choice of the delays between different channels of the system, the form of the signal fed to the antenna, management of possible jitters and maladjustment present along the feeding line and the determination to which extent and how the chosen radiating element acts on the final irradiated pulse.

To the end of better understanding such relations and influences, let us consider the architecture of the system according to an aspect of the invention.

**3.1 Architecture of the system according to an aspect of the invention**

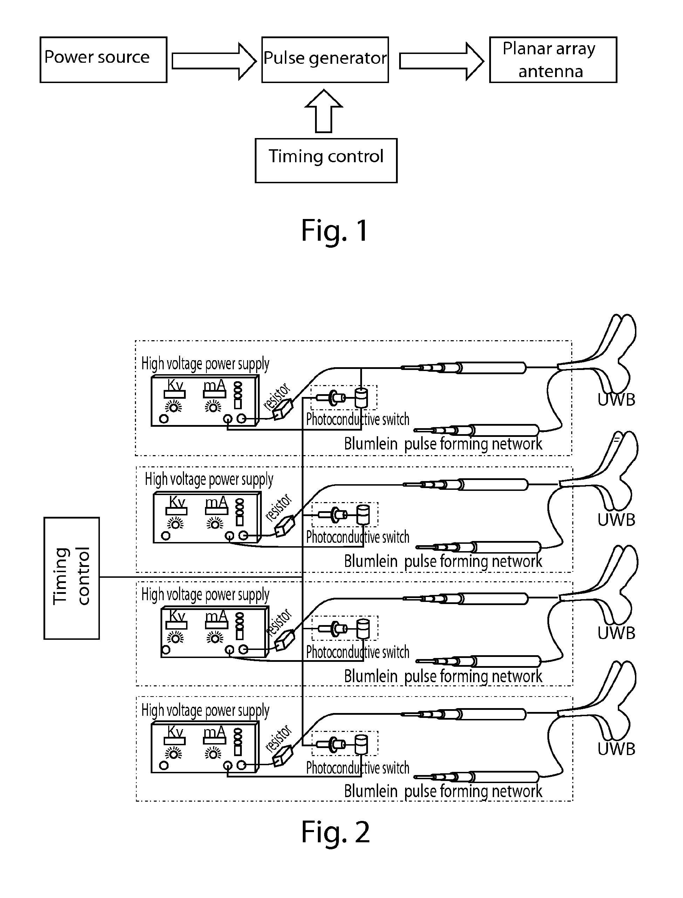

The block diagram of the system according to an aspect of the invention is shown in Fig. 1, wherein a power source supplies a pulses generator, which is controlled by a timing unit. The so generated pulse is fed to an antenna, which is part of an array of antennae.

The system according to the invention is indeed characterised by a plurality of modules (indicated by dashed rectangles in Fig. 2). Such modules are controlled by a shared timing system, and each module is e.g. constituted by the following components:

- high voltage generator;
- static resistor;
- diode with high inverse tension (that is part of the photoconductive diode);
- laser (that is part of the photoconductive diode);
- coaxial cables;
- UWB antenna.

To the end of inhibiting the functioning of the electrical and electronic components of an electronic apparatus, it is necessary to irradiate a series of pulses with very strict specification in terms of (very short) duration and (very high) strength. In particular, the single pulse must be a high voltage pulse (of the order of magnitude of tens of kV) and have a spectral content comprised in the range of 350-1250 MHz. Such a pulse with therefore have to be of duration of the order of the nanosecond and have a rise time of the order of 200-300 ps. Moreover, it has been estimated that the PRF (pulses repetition frequency) of such a pulse should be higher than a kHz.

To the end of exciting at the same time all the frequencies contained in the range of interest, and therefore irradiating a suitable pulse able to interact instantaneously with the electric/electronic components of an apparatus (without having to wait a steady-state condition for each frequency), it is necessary to work in the transient regime and, as a consequence, in the time domain. Moreover, the strict requirement of a high power of the signal that we lead to reach the target at a certain distance implies that a single antenna is not sufficient, rather an array of antennae is needed, wherein the signals (pulses) irradiated by each antenna combine with each other to the end of having the desired output pulse.

As above explained, an array of antennae working in the time domain is called "timed array" and is characterised by a working principle and synthesis procedures well different from those of the traditional array. In particular, an aspect very important for a timed array is the timing.

It is needed therefore that all the modules of the system according to the invention be controlled by a suitable timing unit having a high accuracy. Such a timing system will control each laser diode that triggers the generation of single pulse for the single module. In order that the irradiation direction be exactly determined and the pulses combine in the desired way, it is therefore important to have errors which are the smallest possible ones in the timing system and that analogous components between the various modules have as equal as possible response times.

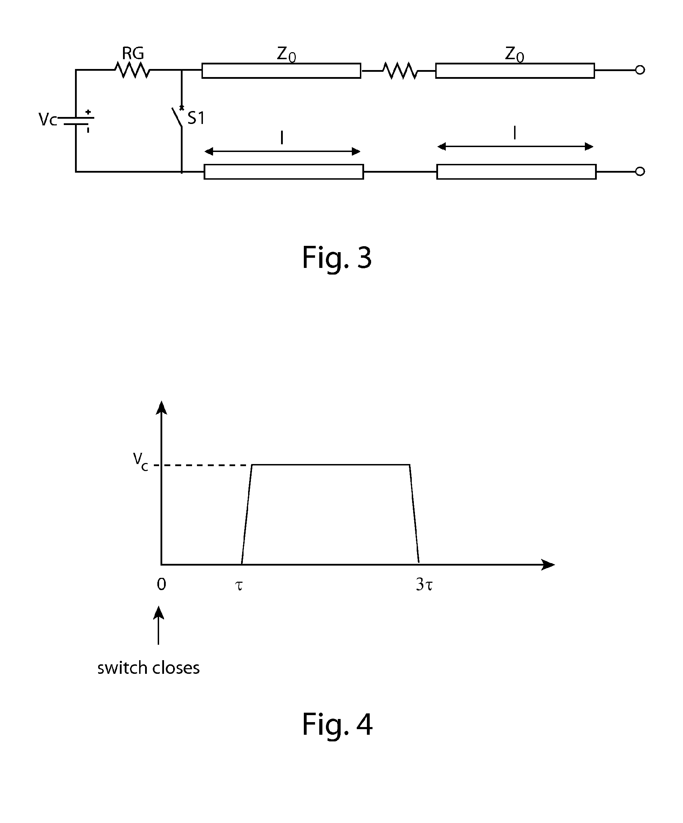

Each module of the system according to an aspect of the invention comprises a high voltage generator put in parallel with a photoconductive switch. Between the generator and the photoconductive switch is moreover inserted a static resistor ($R_g$ in Fig. 3) to the end of protection.

Alternatively to the voltage generator, the system according to the invention can be supplied directly by a car or ship (wherein it would be installed), by using a suitable transformer that converts from alternating regime (ac) to continuous regime (dc) and a capacitors bank able to storing energy.

The architecture of the operators according to the invention can be advantageously described as utilizing a classical Blumlein PFN ("pulse forming network"), modified.

The object of the voltage generator is to load the Blumlein line. The latter is a line that classically is able to generate a voltage pulse that is as much as possible squared and of short duration. Instead, according to an aspect of the invention, by varying the functioning modes of the Blumlein's components, the Blumlein is utilized, as explained in the following, to generate desired voltage pulses. In particular, the PFN Blumlein comprises, in a suitable configuration (Fig. 3), besides the above-mentioned components (generator, switch and static resistor) also to transmission lines and a resistor in series between the two lines and having impedance equal to the double of the impedance characteristic of the same lines. Whilst a line is connected to the switch, the other one will end on an open circuit.

As one can observe in Fig. 3, the circuit is composed by two transmission lines in series, one terminating with an open circuit and the other one terminated to ground by a switch, and a load whose impedance is equal to 2 times the characteristic impedance of the single transmission lines.

The two transmission lines have the same physical characteristics, as well as the same length, in such a way that the propagation time of the signal along each line is equal to T, wherein 2*T is the desired duration of the pulse.

The object of a PFN Blumlein is to generate high voltage pulses that are as much rectangular as possible with very short rise and fall times. Therefore, objectives for the correct functioning of the Blumlein are:

> 1) the switch should be as ideal as possible and therefore it should have an opening time as short as possible and an internal resistance as low as possible;
> 2) the transmission lines should be all exactly equal;
> 3) the right end (in Fig. 3) should be an open circuit.

In the system are subject matter of the present invention one wishes to irradiate a pulse, therefore instead of the resistor, an UWB antenna will be inserted that has an input impedance as real and constant as possible and with a value that is twice the value of the characteristic impedance of the transmission lines.

Since the objective of the system of the present invention is that of irradiating a pulse with desired form, and therefore to feed that the antenna with a pulse of suitable form (as defined by the beamforming algorithm), such objective deviates from that of generating a pulse as squared as possible. To the end therefore to introduce different freedom degrees which will enable to act on the pulse fed to the antenna (in terms of form and duration) the present invention provides in particular the modification of the classical architecture of a PFN Blumlein. In particular:

- Instead of designing a switch that this is as ideal as possible (as above explained), one utilizes the parameters of the same switch as degrees of freedom, to obtain the desired pulse. For example, the objective is not any more to have an opening time equal to 0, but a suitable value of such a parameter is derived.
- The two transmission line segments can have lengths that are not equal to each other, because even such lengths represent degrees of freedom for the designing of the final system.
- In place of the open circuit, a resistor can be introduced which represents a further degree of freedom for the generation of the pulse. Clearly, for very high values, such resistor can simulate an open circuit, and for suitably determined smaller values can modify the reflection coefficient of the termination and, as a consequence, the output pulse.

The feed network of each module of the proposed system according to an aspect of the invention, differentiates therefore from a classical PFN Blumlein, since one acts on different parameters (which is fed for a classical Blumlein are fixed or tending to predefined values as much as possible) to modify the output pulse. What can be a great disadvantage for the functioning of a Blumlein (the present of a non-ideal switch, the inequality of the lengths of the two transmission lines, the lack of actual open circuit in termination in the right of Fig. 3), is used in the architecture of the present invention as an advantage for the generation of the output pulse.

It is here to be specified that in the here proposed architecture the coaxial cable has been chosen for the realization of the Blumlein as a type of line of transmission, but this can be done in any other different suitable way. Then, instead of the typical resistor of the Blumlein, a UWB antenna has been inserted and a photoconductive switch (composed by laser plus diode) has been used as switch. The use of the Blumlein in the structure is a specific feature of the invention; in other application fields, one can use other types of transmission lines, choose whether the pulses radiated by an antenna or substitute the resistor with any other thing (for example cancer cell in medicine) and use other types of switch (slower, depending on the chosen applications) .

During the loading of the Blumlein, therefore, the photoconductive switch is open (so as not to short-circuit the generator itself) (see Fig. 3). The voltage generated by the generator, unless there are falls due to the internal resistances of the cables, switch and static resistor, will become the amplitude of the pulse generated by the Blumlein. Moreover, the larger is the current provided by the generator as input, the sooner the Blumlein line will load.

Once the Blumlein line, in the architecture proposed characterised by coaxial cables disposed in a certain configuration that will be explained in the following, is loaded, the time and control system makes the photoconductive switch close, short-circuiting thus the generator and a starting the generation of the pulse in the Blumlein network.

The chosen typology of photoconductive switch has been that of junction, since it is characterised by rapid response times and high dark resistance.

The photoconductive switch realized for the system according to the invention is for example constituted by a laser and a counter-polarized diode. The laser illuminates (through an optical fiber connection) the semiconductor present within a diode, that is high performing in terms of supported maximum inverse tension and maximum forward current value.

The features of the laser are constituted by a fiber output, power, rise time and duration of the pulses that can be tuned within certain ranges, a suitable wavelength for the semiconductor composing the diode, irradiated pulses having as much rectangular as possible form and a driver with external trigger.

When the semiconductor (silicon junction) of the counter-polarized diode is illuminated by the laser, one has the conduction effect on the diode and therefore the so realized switch passes from "open" (counter-polarization of the diode) to "closed" (illumination of the diode). Thanks to the most rapid response time of the silicon to the received laser pulses, the transition time (ON-OFF) of the switch can be of the order of hundreds of picoseconds.

The realization of a so rapid switch (and also the most possible ideal switch in terms of internal resistance: very small in the ON state and very large in the OFF state) is very important to the end of the performances of the Blumlein network, to the end of obtaining an output narrow pulse, having rapid rise times and without tails. Moreover, by acting on the characteristics of the laser, it is possible to carry out the modification that could vary in a controlled way the output pulse, to the end of obtaining a possible adjustments and diversifying the output waveforms and their band.

Further components of the PFN Blumlein, besides a generator and switch, are represented by two transmission lines segments and a resistor as disposed according to the diagram of Fig. 3.

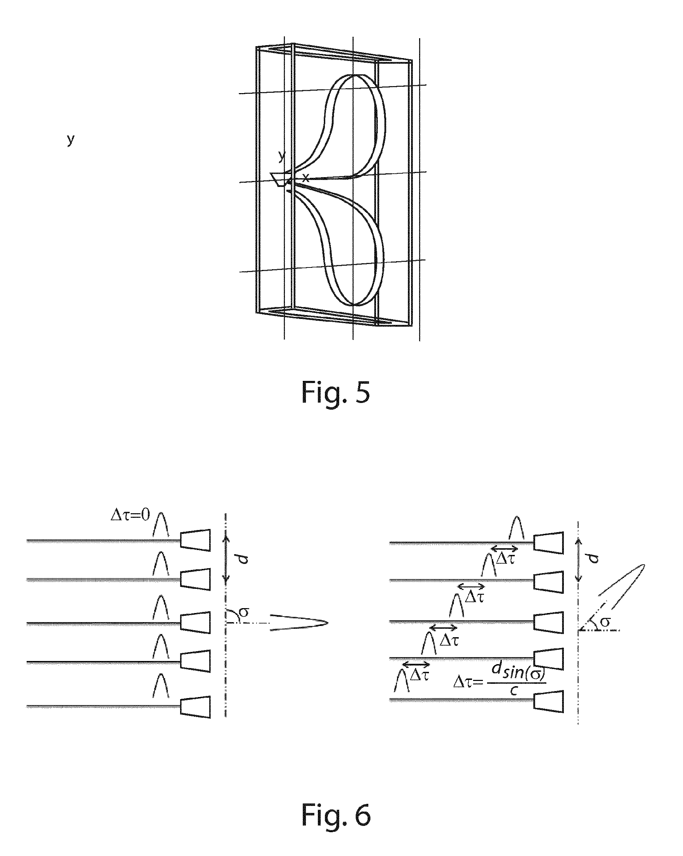

As one can observe in Fig. 6, the resistance of the Blumlein is equal to 2 times the characteristic impedance of the single segments of transmission line.

At the beginning of the process of formation of the pulse, the Blumlein line, with the switch S1 open, is loaded by the generator to the voltage of the same generator. Once the line is loaded, the switch S1 closes; this provokes a discontinued in that implies the generation of a voltage wave which will undergo a series of partial or non-partial reflections and transmissions, propagating forwards and backwards in the two segments of transmission line. Such reflections are due to the presence of the intermediate resistor (cf. intermediate resistor R in Fig. 3), the short-circuit (generated by the closed switch) and the open circuit (termination of the second segment of the transmission line).

After a certain time $\tau$ (time taken by the wave to travel along the first segment of line and connected to the dielectric characteristics of the transmission line as well as its length), at the ends of the resistor a pulse starts to generate which will have duration equal to $2\tau$ (Fig. 4), more or less squared, depending on the characteristics of the switch, and having voltage equal to that of the generator (unless possible voltage leakages in the same switch and along the line).

To the end of further increasing the pulse power, with respect to that provided by the generator, it is possible to make use of a plurality of connected Blumleins that allow the achieving of a total voltage on the load equal to $nVc,$ wherein $n$ is the number of the interconnected Blumleins.

With respect to the diagram as shown in Fig. 3, in the system according to an aspect of the invention, in the place of the resistor, an UWB antenna is inserted having input impedance as real as possible and equal to $2Z_0$. As above said, such an antenna, to the end of transmitting the pulse, will have particular characteristics. First of all, it is necessary that it supports a very high power and guarantees a good gain in the band 350MHz-1250MHz. Moreover, to the end of the radiating a very narrow pulse and distorting it as little as possible, it is necessary that the antenna, has just mentioned, has an input impedance as real and constant as possible in the chosen frequency band. The adaptation of the feed line with the antenna should be made in such a way to have, in the system "line + antenna", an only travelling wave. Always not to distort the pulse, it is therefore necessary that the structure "antenna + Blumlein line" guarantees a TEM mode, being it non-dispersive with the frequency, and to use an antenna that guarantees a smooth transition between such a structure and the free space.

For example, the Valentine antenna, characterised by an almost totally real impedance, gives a low distortion of the input pulse. Moreover, it being constituted mainly by a countersunk metallic strip, adapts well to the high-power applications and is moreover simple to be realized. A further characteristic to be taking into account is that the Valentine, because of its conformation (cf. Fig. 5), adapts well to the array disposition.

Concerning the synthesis procedure of the antennae array, the transient regime requires synthesis procedures that are absolutely different from those in the frequency domain and not yet well-established. For example, among the various differences between the two (time and frequency) domains, it is possible to verify that the pulse irradiated by the antenna in the time domain is proportional to the derivative of the pulse fed as input to the same. The irradiated signal, which will hit the target, will be therefore the derivative of the pulses generated by the PFN Blumlein, with its own amplitude and spectral content.

One of the advantages of the architecture according to the invention is that it uses a (high) voltage generator that does not require working at a particularly high power. Indeed, the required current is not large thanks to the use of the PFN Blumlein.

### 3.2 Beamforming for the system according to the invention

Once the architecture has been described, it is possible to better detail the procedure of beamforming.

As mentioned above in section 2, for the system according to the invention one has the need to irradiate a pulse, provided with a certain form, band and amplitude, in a well-defined region of the space (to the end of pointing well the target, acting only on that and not on the other neighboring apparatuses and to the end of not dispersing the energy itself). To do that, it is necessary that the pulses fed to the single radiating elements (antennae) constituting the antenna array fulfill specification in terms of optimal duration, amplitude and form and that the single antennae have a behavior as ideal as possible in all the irradiation directions.

It is therefore objective of the beamforming procedure to guarantee that the antenna array irradiates a pulse having a priority determined specifications (in terms of band, beam width and energy content) and that such specification are respected along all the desired irradiation directions. It is to be remarked that the characteristics of the irradiated pulse derive from a study of the effects that it has on the semiconductor devices that the system of the invention is aimed at neutralizing.

Such an optimization procedure is not trivial because the parameters to be determined for the pulses fed to the single antennae are connected to as many parameters of the pulse generation line, that is, to the end of fulfilling such specification, it is necessary to act on all the blocks of the system according to the invention (see Fig. 1) and, specifically, even on several components of each block. To fulfill the requirements of the irradiated pulse, it is necessary to act on the components of the pulses generator of the invention and therefore on the laser beam controlling the photoconductive switch, of the characteristics of the switch itself and on the length of the transmission lines constituting the Blumlein. Concerning the characteristics of the switch itself, one could act on the doping of the diode etc, to change the on/off resistance etc. The timing procedure that will be illustrated in detail in the following does not provide as variables the physical parameters of the diode, assuming that one has already assigned the physical characteristics (dimensions, doping, materials, etc) of the diode itself. This is not a limitation of the timing procedure that, in case it is possible to work on this parameters, can take into account even such variables without any particular critical issues.

All this is per se not sufficient because it is necessary that the radiating element be adapted to the line in such a way not to disperse power and distort the pulse, i.e. without widening or modifying the form that one wants to obtain as output. Even in the case wherein the Pulse Generator and Antenna Array blocks are perfectly functioning, this would be in any case not sufficient. It is necessary indeed that there is an optimal timing between the pulses irradiated by the single channels, and that such timing is then managed in an optimal way by the Timing Control block.

To the end of implementing therefore a method able to optimize the such parameters it is necessary to deepen the relationships between components of the system according to an aspect of the invention and characteristics of the irradiated pulse. Such relationships are better explained in the following paragraphs.

### 3.2.1 Influence of the form of the pulse generated by the pulse forming network (PFN) on the total irradiated pulse

To the end of obtaining a certain band of the output signal, it is indispensable to define the characteristics of the signal fed to the antenna by the pulses generator of the system according to the invention, in terms of waveform, duration, rise time and fall time. All these characteristics influence the band of the output signal. Let us consider initially the form of the pulses generated by the PFN and fed in input to the antenna. Generally, the pulses can be of different forms: rectangular, trapezoidal, Gaussian, double Gaussian, exponential, etc. Moreover, by varying the parameters of the components constituting the PFN Blumlein, it is possible to obtain further variations with respect to the traditional waveforms.

The waveform to be generated as output of the system according to the invention not only, as above mentioned, should allow an output waveform having the interest band of the system according to the invention (350-1250 MHz), but it should be a waveform that is robust with respect to noise. It is indeed possible that the instant of generation of the different pulses be slightly shifted because of the presence of the noise introduced for example by thermal phenomena or by some small difference between analogous components of the various modules. Such a noise should influence to the smallest possible extent the band and the other general characteristics of the total pulse outputting the system according to the invention. By considering that the output of the system according to the invention is a suitably synchronized summation of the different pulses, a so-called "robust" waveform should act in such a way that a slight and random time delay of the different pulses does not modify in a significant way the output signal and, therefore, the system performances.

A further consideration to be taking into account concerns the ability of the system to scanning. The scanning of a timed array provides indeed that the different pulses undergo in succession a time delay connected to the chosen scanning direction. As explained in section 1, such a scanning implies a widening of the output pulse and a consequent distortion of the same. The required robustness for the waveforms of the input pulses should be able to take it into account and reduce such an effect as much as possible.

The beamforming procedure according to an aspect of the present invention provides an iterative procedure for the choice of the suitable waveforms (pulses fed to the single antennae), angle by angle and channel by channel. To this and, the procedure will derive the optimal waveform by varying, within a certain range (or more disjointed ranges) depending on the technologies to be used, parameters comprising:

- lengths of the transmission lines constituting the pulses generators;
- characteristics of the photoconductive switches (opening and closing times of the switch, on-off duration).

Clearly, when one speaks of transmission lines lengths, it must be specified that they can be conveniently predefined as well, at most optimized by the method according to the invention, or one can realize the device which has re-configurable transmission lines.

It is to be noted that the characteristics of the switch are controlled by varying the characteristics of the laser beam (rise time, duration, fall time) which controls the opening and the closure of the photoconductive switch.

The beamforming method according to the invention will optimize the above-mentioned parameters to the end of obtaining for each decide scanning angle the waveform of the irradiated signal which reduces at the minimum the power waste on the tails (factor that is very important for a high power system such as that of the invention), has the interest band and maximizes the energy in the direction of interest. Such an optimization is made by taking into account (as constraints) the chronological limits of the components and the behavior of the antenna as a function of the scanning angle.

In particular, such a synthesis method will make the optimal choice by considering as objectives the maximization of the energy contained in the irradiated pulse, a width of the pulse at broadside (orthogonal to the line or the plane of the antennae of the array) and then in scanning (that will be called Beam Width or BW and indicates how much the pulse is wide and therefore in how much space the energy contained therein is distributed), and possibly a certain tolerance on the possible tails contained in the signal.

It is to be specified that among the (both input and output) parameters, the method may provide a certain hierarchy of priority, introduced in the same method by a certain vector known as "weight vector".

Summarizing, in order to guarantee that the irradiated pulse maximizes the energy as much as possible (and respects the band values and the beam width) along all the specified scanning directions, the following three ways have be analyzed:

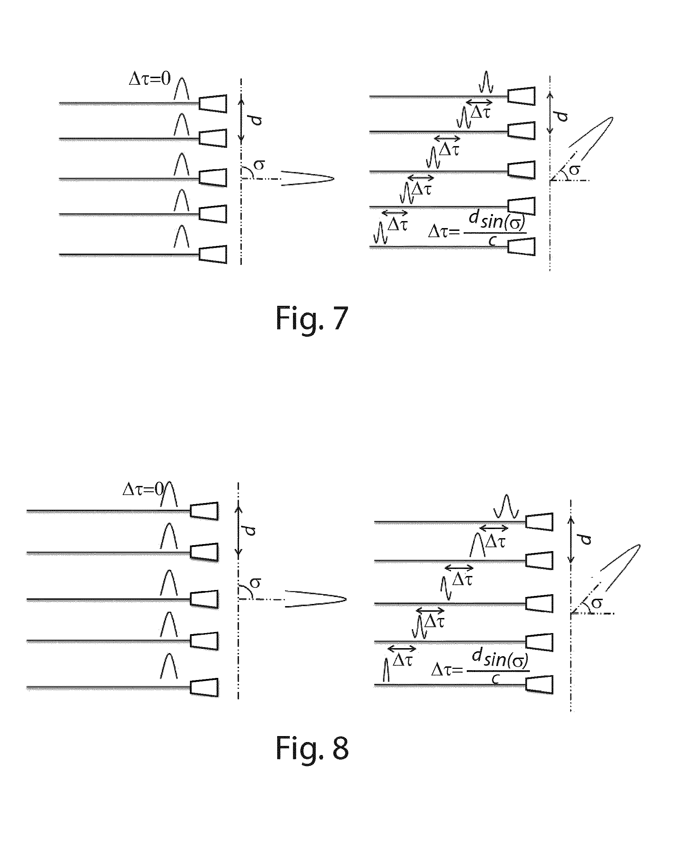

1. Considering a waveform, as robust as possible, of the pulse fed to the antenna, which is equal to all the modules of the system according to the invention and all the scanning angles (Fig. 6);
2. Considering a robust waveform of the impulse fed the antenna, that is equal for all the modules of the system according to the invention, but varies for every scanning angle (Fig. 7);
3. Considering different waveforms of the pulses to be fed to the antennae, which vary both for the single modules of the system according to the invention and for the different scanning angles (Fig. 8);

and the third way has been chosen.

### 3.2.2 Influence of the duration of the pulse has generated by the pulse forming network (PFN) on the total irradiated pulse

In the previous paragraph, by speaking of waveform was meant not only the form of the pulse, but also the characteristic values in terms of duration, rise time and fall time.

Indeed, the so intended form, and therefore the overall form, allows having a precise value of the irradiated signal band that will have to coincide with the band that the system according to the invention should guarantee for some specific applications of interest (350-1250 MHz). Such a band is obviously a characteristic parameter of the semiconductor devices whose functioning is to be inhibited. However, the system and method according to the invention work well per se in any band.

Whilst the only pulse form, intended as pure proportion between duration, rise time and fall time, mostly determined by the characteristics of the photoconductive switch, the duration (at half height) is strictly tied to the length (and more in general to other characteristic parameters) of the transmission lines of the Blumlein. This is not the only mode, since a further degree of freedom that is possible to exploit to this end is the timing that manages the delays of the different pulses outputting from the various channels of the system according to the invention, and also the duration of opening and closing of the switch. In fact, introduction of small variations (that is comparable to the duration of the other pulses) on the duration of the laser pulses as managed by the Timing Control can allow a variation of the duration of the total pulse irradiated by the antennae array and, consequently, of its band.

### 3.2.3 Influence of the timing unit

The timing control unit dictates the delays that the pulses sent to the different channels must have. Such delays are determined by the scanning direction, but can also undergo, with respect to the theoretical formulation, smaller variations that are chosen in such a way not to act directly on the pointing direction, but to intervene only to the end of varying the chosen pointing direction (and therefore on the band) and reducing possible tails of the output pulse as much as possible.

It is fundamental to note that, while in the traditional systems the time delay needed for the delaying the different pulses is introduced after the generation of the pulses, in the system according to the invention a real, subsequent generation has been thought. Generating then the pulses exactly in the moment when they have to be irradiated allows a remarkable simplification of the feed line, since, for example, the use of the True Time Delay (TTD) is not necessary any longer, which allow exactly to timely delay a generated signal having a certain band. This is also possible because the system according to invention, for its aims, is a system operating only in transmission and not in reception.

### 3.3 The beamforming algorithm

Having taken into account, hence, the relationships as described in the previous paragraphs, one proceeds now to the description of the beamforming algorithm. As previously said then, the pulses fed to the single antennae of the different modules of the system according to the invention are irradiated, forming (summing up to) a single pulse. In a timed array , one supposes that all the pulses fed to the single radiating elements are equal and that the subsequent delays introduced in the case under scanning are well determined according to the following formula:

$$\Delta\tau = \frac{d\sin(\theta)}{c} \qquad (3)$$

Wherein $d$ is the distance between two consecutive radiating elements, $c$ is the light speed and $\theta$ is the scanning angle (in case of linear array, as an example). Since the scanning process for a timed array has the disadvantage of an effect of pulse widening, as the pointing direction goes away from the broadside direction, the here proposed procedure does not consider any more the equality of these parameters between the different modules (pulse fed to the antenna and delay between the elements), but introduces to further degrees of freedom, with respect to the classical timed array case.
Moreover, if instead of the simplified case of linear array one considers, according to an advantageous aspect of the present invention, a planar array, then the delays introduced for the scanning will be:

$$\Delta\tau_{x} = \frac{d\sin(\theta)\cos(\varphi)}{c} \qquad\qquad \Delta\tau_{y} = \frac{d\sin(\theta)\sin(\varphi)}{c} \qquad (4)$$

Along the horizontal and vertical directions respectively.
It is here to be specified that, according to the invention, the array can be linear or planar, or any other useful disposition.
As the scanning angle varies, the forms of the pulses fed to the radiating elements are made varying. For example, while at broadside all the pulses fed the single radiating elements are Gaussian with determined characteristics (rise time, duration, fall time, etc), by scanning at a certain angle one can derive that, to the end of compensating the distortion of the irradiated pulse and maintaining them as much as possible the same energetic content, BW and signal band, the pulses fed to the antennae should have a different form (see Fig. 7). A further innovation is that of varying the pulses of the different modules for a determined scanning angle (see Fig. 8). This can be realized in an optimal way by the method according to the invention.
Moreover, even in the case one achieves to obviate to the natural distortion introduced by a timed array in scanning, it is to be taking into account that the real antennae are provided with defective heights that could affect the distortion of the pulse itself and that such effective heights in general vary as the scanning angle varies. Based on the foregoing, one understands well that one should consider the different values of the effective height (of a certain considered antenna) as the scanning direction varies.
That said, the beamforming algorithm, given as input to the specification concerning the pulse that one wishes to irradiate and the radiating characteristics of the antenna, performs a procedure of minimization of a cost functional (depending on the various inputs), obtaining for example the following outputs for each single module:

- timing (delays between pulses, which are here indicated by $\Delta\tau_x$ and $\Delta\tau_y$ in accordance to what has been previously said);
- duration (T), Rise Time ($t_{rise}$) e Fall Time ($t_{fall}$) of the laser pulses for each single module of the system according to the invention (and more in general $t_{open}$ and $t_{close}$ a generic switch);
- length of the transmission line (in general, a set of length parameters $L_{tx}$, for example in the case of the Blumlein one has to parameters of length for each single module of the system according to the invention;

once assigned the following parameters in input:

- Width of the desired irradiated pulse BW (chosen on the basis of the instantaneous action radius, i.e. on the basis of the angular region wherein one wants it to be distributed, for each instant, the energy contained in the pulse) in the considered directions;

- Band: $\Delta f$: [$f_{min}, f_{max}$] as defined therefore between $f_{min}$ and $f_{max}$;
- Scanning region: $\Delta\theta$: [$\theta_{min}, \theta_{max}$], $\Delta\varphi$: [$\varphi_{min}, \varphi_{max}$];
- Effective height of the considered antenna: $h(\theta,\varphi)$.

It is here to be noted that the effective height differentiates from the other input parameters in that it does not represent a specification to be fulfilled, but a technological constraint to be taking into account. It is moreover possible to include, among the inputs of variation ranges, the technological limits that some of the components of the PFN Blumlein can represent, such as for example the ranges from which it is possible to vary the duration and the rest time of the laser pulse $\Delta t$: [$t_{min}, t_{max}$], and possible other limits.

The cost functional to be minimized will be therefore the following:

$$\Phi\ (\Delta\tau_{x}\ ,\ \Delta\tau_{y}\ ,\ T,\ t_{rise}\ ,\ t_{fall}\ ,\ L_{tx}).$$

Wherein the parameters $\Delta\tau_{x}$, $\Delta\tau_{y}$, **T**, $t_{rise}$ , $t_{fall}$ , $L_{tx}$ are vectors whose components correspond to the various modules of the system. In general, instead of $t_{rise}$ , $t_{fall}$ one can have $t_{open}$, $t_{close}$ in the case of a general switch.

It is here to be specified that the functional can also not comprise the lengths $L_{tx}$, because in the practice is difficult to construct lines of reconfigurable lengths, or it can comprise only the lengths $L_{tx}$ , optimized and equal to all the emission angles.

Such a minimization will be performed by a global optimization algorithm, known as simulated annealing (SA). Among the different global optimization algorithms (which have as objective the research of an absolute minimum in the presence of local minima), the simulated annealing comes out to be the most adapted. The concept of annealing derives from the metal science, wherein it is used to describe the process of elimination of lattice defects from the crystals by a heating procedure followed by a slow cooling down.

The SA is a research methodology that is highly adapted for any non-convex optimization problem.

The SA algorithm is therefore utilized to the end of minimizing the nonlinear cost functional as defined and obtaining as output, channel by channel and angle by angle, the optimal interest parameters (delays, rise time, fall time, duration, lines length) to the end of obtaining iteratively before of the pulse that is closest to (in the considered norm $L^2$) the desired output one (the one maximizing the peak power in the considered direction).

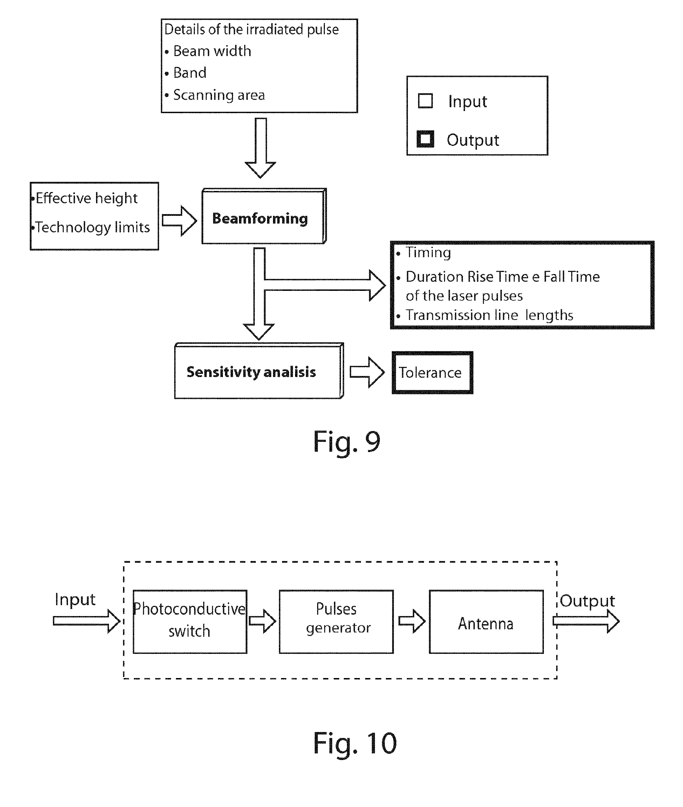

Once the optimal parameters are established, the proposed beamforming procedure with therefore a sensitivity analysis (as in the prior art) to the end of verifying the values of the jitters that are acceptable for each single module of the system according to the invention (see Fig. 9).

At the end of such procedure may follow a calculation of the average power, to the end of deriving the optimum PRP ("Pulse Repetition Frequency") to the end of:

1. Keeping the level a predefined threshold; and/or
2. Maximizing the level of interference on the components.

### 3.4 Details of the functional optimization procedure

As above illustrated, in the beamforming algorithm, the output parameters, and therefore the parameters on which one can act to satisfy the input specification, are represented by:

- Timing (delays between pulses);
- Duration, rise time and fall time of the laser pulses for each single module of the system according to the invention;
- Length of the transmission line for each single module of the system according to the invention;

Whilst the input, therefore known parameters are:

- Width of the desired irradiated pulse: BW (has chosen on the basis of the instantaneous action radius, i.e. on the basis of the angular region wherein one wants the energy of the pulse to be distributed, at each instant in the considered directions);
- Band: $\Delta f$: [$f_{min}, f_{max}$] as defined therefore between $f_{min}$ and $f_{max}$;
- Scanning region: $\Delta\theta$: [$\theta_{min}, \theta_{max}$], $\Delta\varphi$: [$\varphi_{min}, \varphi_{max}$];
- Effective height of the considered antenna: $h(\theta,\varphi)$;

- The intervals for which it is possible to vary the duration and the rise time of the laser pulse $\Delta t$: $[t_{min}, t_{max}]$;

The cost functional $\Phi$, to be minimized, based on a foregoing aspect of the invention, with depend on the following parameters:

$$\Phi\left(\Delta\tau_x, \Delta\tau_y, T, t_{rise}, t_{fall}, L_{tx}\right)$$

It is defined as the quadratic norm of the difference between a function $g$ that depends on of the unknown variables of the problem, and therefore on the parameters $\Delta\tau_x$, $\Delta\tau_y$, $T$, $t_{rise}$, $t_{fall}$, $L_{tx}$, and a target function $G_0$. Such a target function includes the information concerning the distribution of the energy in the space that one wants to obtain (by maximizing in some regions of the space and minimizing in some other regions) thanks to the optimization algorithm. The algorithm will therefore have as objective that of obtaining the parameters values $\Delta\tau_x$, $\Delta\tau_y$, $T$, $t_{rise}$, $t_{fall}$ and $L_{tx}$ in such a way that one is able to get as closer as possible to the target function, and therefore maximize the energy in a given region of the space (and in the interest band).

The so defined functional will be therefore the following:

$$\Phi = \left\| g\left(\Delta\tau_x, \Delta\tau_y, T, t_{rise}, t_{fall}, L_{tx}\right) - G_0 \right\|^2$$

The function $g$ is characterised, because of the complexity of the system and the number of involved variables, by a degree of complexity that does not allow to express it in a simple or closed form. Such a complexity translates into a corresponding complexity of the cost functional.

As a consequence, to the end of describing the determination of such a functional and how the algorithm manages the different input parameters and connects them to the output parameters, the following models and numerical models have been adopted.

Indeed, the transfer function connecting the input to the accident of the system of beamforming is implemented numerically. In particular, making reference to Fig. 10, the system is constituted by a plurality of intermediate stages and a function $g$ includes the different input-output transfer functions of the intermediate stages, representing an energy (irradiated in the space) that contains in itself the relationship between the output and the input of the total system. The first stage is represented by the photoconductive switch (therefore constituted, according to the invention, by a laser illuminating the junction contained in the diode).

The choices on the diode junction and how it is illuminated are determined a priori (making reference to the reasoning made on the design and realization of the photoconductive switch as above).

The following parameters of the photoconductive switch block are already known:

- Semiconductor material;
- Geometry and dimensions of the junction;
- Material properties (absorption coefficient etc);
- Doping;
- Illumination area;
- Presence/absence of external recombination phenomena;
- Applied inverse voltage;
- Laser wavelength;
- Intensity of the laser pulse.

The input parameters, that are the ones to be determined, are those that is possible to vary by using the chosen laser and within certain ranges (technological limits that are one of the two constraints given in input to the beamforming algorithm, Fig. 9), i.e.:

- instant of the generation of the laser pulse;
- duration of the laser pulse (T);
- rise time of the laser pulse ($t_{rise}$);
- Fall time of the laser pulse ($t_{fall}$).

The first input is dictated by the control timing unit on the basis of the considered scanning angle (the procedure that will be described in the following will be repeated for all the scanning angles). In particular, the delays with which the different lasers will be operated are described by the above formula (4). Such activation instants, analytically derived, may, during the procedure illustrated in the following, undergo small variations, to the end of minimizing the cost functional as much as possible.

Once the other three inputs are considered, and on the basis of a priori known information, a finite-elements analysis will be carried out for the resolution of the equations of the carriers transport in the semiconductors, for a single dimension. As a result, such analysis will give back the progression of the internal resistance of the switch in the OFF and in the ON mode along time.

Once this output is known, it will constitute the input of the second stage, that is relevant to the pulse forming network. On the basis of the resistance of the switch, along time, and at the length $L_{tx}$ of the transmission lines, an analytical model has been implemented which describes the propagation of the waves, in the transitory regime, along the Blumlein (see above). The output of such a stage will be represented by the pulse fed to the antenna.

Once the latter is known, the third stage, on the basis of the characteristics of the chosen antenna (they also given in input, in terms of effective height, as constraint in the algorithm, Fig. 9), will determine the irradiated pulse, its BW and the associated band (making also reference to the formula (2)).

Practically, this means that a simulation model is assumed for each stage, and therefore a total simulation model, which provides as a matter of fact the functional to be minimized, more precisely the value of the functional at the n-th iteration of the minimization.

The above described succession of the simulations will be in fact made backwards, by a synthesis algorithm that, given the outputs, will derive the inputs. Starting down from the irradiated pulse, the length ($L_{tx}$) of the transmission lines in the PFN Blumlein and the characteristics of the laser pulse (T, $t_{rise}$, $t_{fall}$) will be determined.

Moreover such a procedure calls for a fixed direction ($\theta,\varphi$). It will be therefore repeated for each possible direction (on the basis of the scanning region given in input to the beamforming algorithm, Fig. 9).

On the basis of the optimal parameters ($\Delta\tau_x$, $\Delta\tau_y$, T, $t_{rise}$, $t_{fall}$, $L_{tx}$) as determined for each scanning direction, the single relevant energies will be summed up in a suitable and coherent way and such summation will represent the optimized transfer function of the system.

### 3.5 Specific example of calculation and optimization of the functional

One will consider in the following the most complex case of a photoconductive diode (larger dimensions of the unknown space) together with the Blumlein and the diode modeling, so as to treat the most general and comprehensive case.

Once the target function $G_0$ is assigned, which represents the waveform irradiated by the considered antennae array, the objective is to determine the unknown vectors $\Delta\tau_x$, $\Delta\tau_y$, **T, $t_{rise}$, $t_{fall}$, $L^1_{tx}$, $L^2_{tx}$** that allow to generate a function that most approaches the target function.

To the end of providing a clear explanation of the proposed algorithm, it is to be stated that the blocks of Fig. 11 have an nonlinear input-output relationship. Moreover, to the end of the exact calculation of the algorithm (if one wants to achieve an optimal solution), the blocks cannot be calculated separately since all the variables should be made varying at the same time.

The function $g$ represents therefore the input-output relationship within the beamforming block, which has been obtained by means of numerical simulation of the single transfer functions of the sub-blocks of which is it is constituted. The problem under examination can be therefore mathematically formalized as the minimization of a functional $\Phi$ in the norm $L_2$:

$$\Phi = \left\| g(\Delta\boldsymbol{\tau}_x , \Delta\boldsymbol{\tau}_y , \mathbf{T}, \mathbf{t}_{rise} , \mathbf{t}_{fall} , \mathbf{L}^1_{tx}, \mathbf{L}^2_{tx})\text{-}G_0 \right\|^2$$

The SA global minimization algorithm has been detailed above.

Here, for better clarity, a description of how each of the transfer functions has been obtained will follow. With reference to Fig. 11, a mention on the different blocks is given.

Timing control block

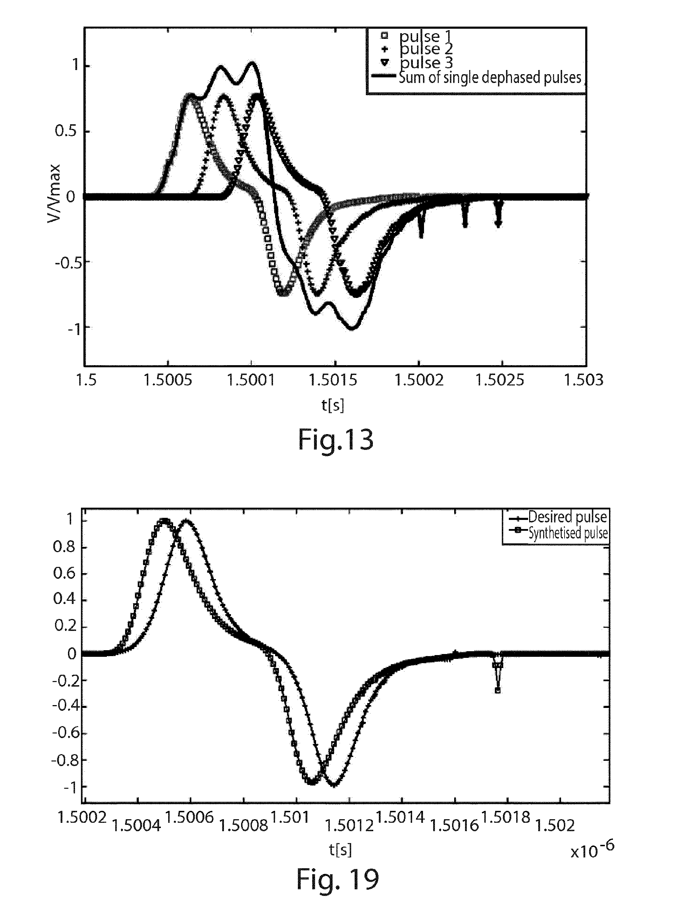

This block is responsible of the parameters $\Delta\tau_x$, $\Delta\tau_y$ which represent the enabling delays of each module (e.g. planar array in the x,y plane) with respect to a reference instant t=0. By varying this delay, it is possible to mainly orientate the beam of the array in a certain direction (θ,φ) (Fig. 12, wherein in (a) and (b) the signal emitted in two different directions has been measured). It is possible to utilize (generally smaller) delays to combine in output the pulses with each other in such a way to realize different waveforms (Fig. 13). It is therefore clear that being able to act on this parameters is fundamental in order to minimize the functional Φ.

*Switch Block*

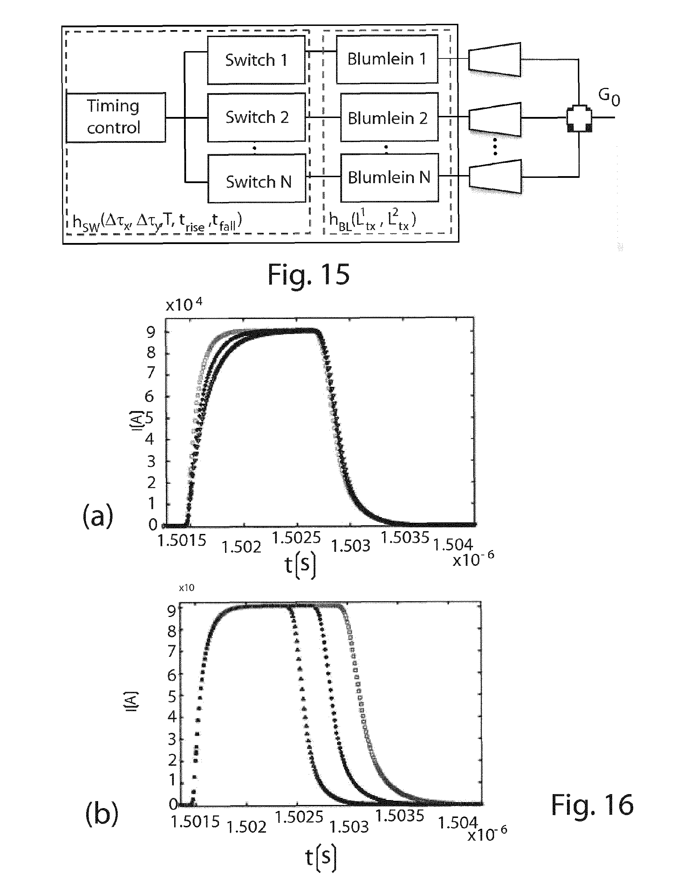

This block is responsible of the parameters $T$, $t_{rise}$, $t_{fall}$, which represent respectively the duration, the rise time and the fall time of the laser pulse which will enable the photoconductive diode. To the end of obtaining the transfer function of this block, it is necessary to model the behavior of the photoconductive diode as illuminated by a laser pulse with the above described parameters. This can be realized both by implementing a finite-elements method for the resolution of the equation of the carriers transport in the semiconductors, and utilizing a commercial simulator (for example pc1d). In both cases, it is possible to obtain the current passing through the photoconductive diode in the time domain as the utilized laser parameters vary (Fig. 16). From the current, the impedance will be easily calculated.

Blumlein (pulse generator) block

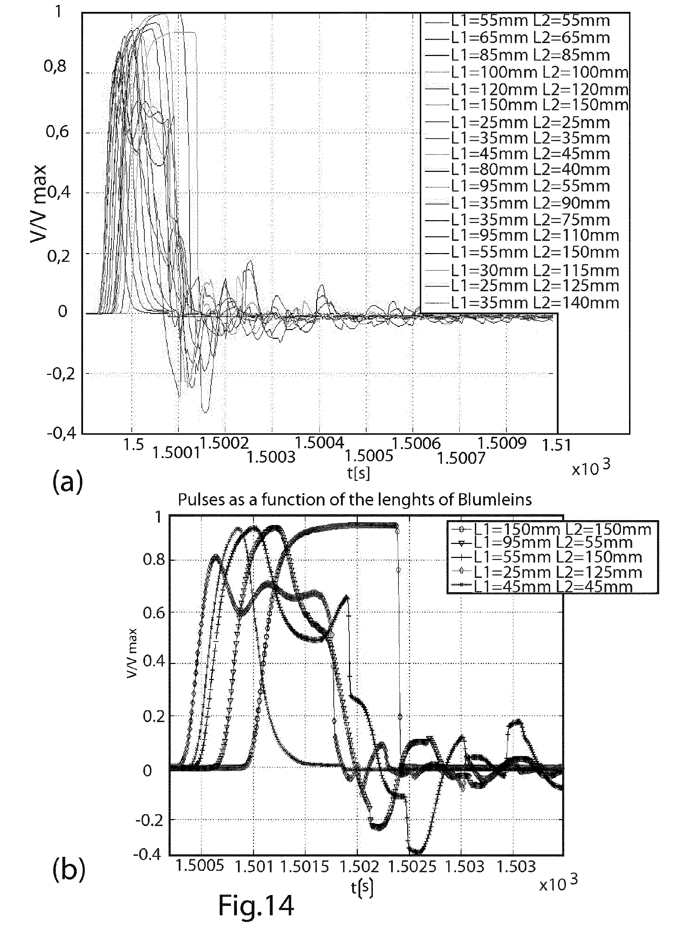

This block is responsible of the parameters $L^1_{tx}$, $L^2_{tx}$ which represent the length of the two transmission lines of which the Blumlein is constituted. This block is the interface of the overall system with the single antenna of the array.
To the end of obtaining the transfer function of this block, it is necessary to model the specific transitory phenomenon of the Blumlein, taking into account the characteristics of the switch (output of the previous block), the characteristics of the antenna (effective height in the time domain, input impedance) and the non-ideality of the transmission lines constituting the Blumlein (leakages, capacitive/inductive effects). This can be made both implementing codes (for example by Matlab) that provide the pulse fed to the antenna as the parameters $L^1_{tx}$, $L^2_{tx}$ are varying, and utilizing commercial simulators (e.g. PSPICE, ADS) (Fig. 14). As one can see from the Fig., by simply changing the values of $L^1_{tx}$, $L^2_{tx}$, the output pulse changes its time characteristics. In particular, the reason significant change in the form of the pulse that, by increase of the parameters $L^1_{tx}$, $L^2_{tx}$, augments its duration.
Once all the input-output relationships of the system have been numerically defined, the simulated annealing (SA) algorithm iteratively seeks the solution that minimizes the functional Φ. Being SA a global minimization algorithm, the starting point of such an algorithm notably influences the possibility to reach the optimal solution (global minimum). For such a reason, one has chosen to utilize a starting point chosen with the following criteria (close to the theory

forecasts):     $$\Delta\tau_x = \frac{d_x \sin(\theta)\cos(\varphi)}{c}$$     wherein   θ   and   φ   represent   the   pointing   direction;

$$\Delta\tau_y = \frac{d_y \sin(\theta)\sin(\varphi)}{c}$$   wherein θ and φ represent the pointing direction;   $T = 3L_{tx}^2/c$

$t_{rise} = t_{rise}$ of the function $b(t) = \int G_0 dt$

$t_{fall} = t_{fall}$ of the function $b(t) = \int G_0 dt$

$L^1_{tx} = L^2_{tx} = ½$ of the duration of the function $b(t) = \int G_0 dt$

It is to be noted that, both for the choice of the starting point and for the definition of the ranges wherein SA works, the technological limits of each component have been taking into account (with the correction of the starting point above certain thresholds).
A further development of the method according to the invention (Fig. 11), with the objective to increase the probability to obtain the optimal solution (avoiding to fall down in local minima that are intrinsic to a nonlinear problem), and at the same time to reduce the computational complexity, is to use the hybrid iterative method explained in the following (see Fig. 15).
The method provides to divide into two stages the minimization of the functional Φ. Each stage will have the objective to determine a subset of the unknown variables. In particular, in the first stage the parameters $L^1_{tx}$ and $L^2_{tx}$ of the Blumlein block are fixed (the transfer function $h_{BL}$ of the Blumlein is completely known, since it is equivalent to select for example one of the curves calculated and shown in Fig. 14) and the remaining parameters are calculated which minimize the functional Φ expressed as:

$$\Phi = \left\| h_{BL}(h_{sw}(\Delta\tau_x, \Delta\tau_y, T, t_{rise}, t_{fall})) - G_0 \right\|^2$$

Wherein $h_{sw}$ is the transfer function of the semiconductor switch.

The minimization occurs as in the general case by using SA. It is to be remarked that, being the proposed procedure iterative, at each iteration the solution at the previous step will be considered as starting point. Clearly, in the first iteration the initial point will coincide with that previously indicated for the general case.

Once the parameters $\Delta\tau_x$, $\Delta\tau_y$, T, $t_{rise}$, $t_{fall}$ are therefore determined which minimize the above indicated functional $\Phi$, the second stage is executed, which has the objective to re-determine the parameters $L^1_{tx}$ and $L^2_{tx}$. This stage minimizes a new functional $\Phi$ defined as:

$$\Phi = \left\| h_{BL}(L^1_{tx}, L^2_{tx}) - G_0 \right\|^2$$

Wherein the output of the function $h_{sw}(\Delta\tau_x, \Delta\tau_y, T, t_{rise}, t_{fall})$ is that one determining in the first stage and the starting point of SA is the solution at the previous step.

The proposed iterative procedure will stop in the case wherein the functional $\Phi$ is below a certain predefined threshold or if the maximum number of allowed iterations has been exceeded (which is being decided a priori as well).

It is observed that the proposed hybrid procedure allows to pass from the general problem having 7N unknown variables, wherein N is the number of modules constituting the array, to 2 sub-problems having respectively 2N and 5N unknown variables, that are iterated k times. Considering that the problem is combinatory (NP-hard) the second approach will represent a substantial reduction of the possible combinations.

This allows to improve the here presented synthesis algorithm performances for two main aspects. The first aspect consists in reducing considerably the probability to obtain a solution far away from the absolute optimal, whilst the second concerns the reduction of the computational complexity, allowing to improve the times and the required hardware resources.

Finally, for better detail, a detailed example for an interest case is given for the proposed algorithm, always making reference to the desired pulse (see Fig. 19).

Starting from this desired pulse, and considering the architecture of the antennae array that one wishes to analyze, it is observed that in a case of interest (non-lethal weapon disturbing the electronics of the vehicles), one wishes to maximize as much as possible the field irradiated in a certain direction (broadside in the example) so as to perturb the individuated target. In such a case, the synthesis problem manifests noticeably since one can apply the proposed algorithm to an only channel, being the channels all equal and synchronized to the end of maximizing the irradiated field. This simplification is particularly significant since it allows to reduce the unknown variables of 1/N wherein N is the number of modules constituting the array.

In the considered example, coherently with the foregoing, in the first step ones has set $L^1_{tx} = L^2_{tx} = 55$ mm equal to duration of the pulse fed the antenna of 700 ps.

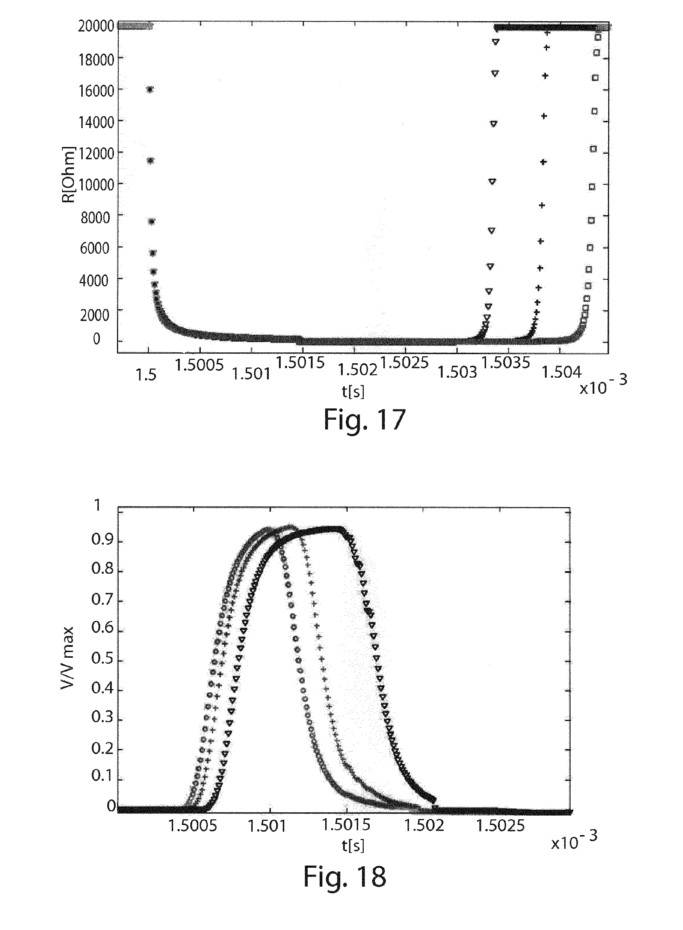

By running the SA algorithm, variables T, $t_{rise}$, $t_{fall}$, $\Delta\tau_x$, $\Delta\tau_y$ are searched for values that minimize the functional $\Phi$ at that step of iteration. In Fig. 17, some outputs of this stage are shown for various iterations.

In the same way, once T, $t_{rise}$, $t_{fall}$, $\Delta\tau_x$, $\Delta\tau_y$ have been calculated, the second stage of the proposed hybrid procedure has been implemented, which allows to calculate $L^1_{tx}$ and $L^2_{tx}$ which minimize the functional $\Phi$. In Fig. 18, some solutions of this stage are shown for various iterations.

In the illustrated case, after 34 iterations (the number of steps you depend on the defined thresholds and the search ranges for the parameters) the proposed algorithm has obtained the parameters $\Delta\tau_x$, $\Delta\tau_y$, T, $t_{rise}$, $t_{fall}$, $L^1_{tx}$, $L^2_{tx}$ which minimize the functional $\Phi$ and allows to have in outputs the pulse shown in Fig. 19 that, as one can see, approximate very well the considered reference pulse $G_0$. The average values of the output vectors obtained by the algorithm (to the end of obtaining the pulse shown in the Fig.) are the following:

$\Delta\tau_x = 15$ ps, $\Delta\tau_y = 19$ ps, T= 1.2 ns;, $t_{rise} = 200$ ps, $t_{fall} = 280$ ps; $L^1_{tx} = 53$ mm, $L^2_{tx} = 55$ mm.

With respect to the above-mentioned prior art documents, (in particular the document US 6,061,034 A and the article of JON S H SCHOENBERG ET AL), it is first of all to be noted that, in the second, reference is made to an only channel with a generic mention to the possibility of an array that, in such a case, would not take into account the architectural flexibility (which instead is here well considered) since the same a priori assumption would be made, which has been made in the first document, i.e. that all the modules are equal. Moreover, unlike the case of the present invention, in the prior art the results are obtained empirically without specifying or suggesting any method of the determination of the parameters constituting the architecture and the output waveforms.

Moreover, the architecture proposed by the present invention does not present at all the Power Modulator block. In particular, in the present architecture, the modulation of the pulse form is carried out directly by using the laser, photoconductive diode, timing and Blumlein, which is not only utilized to store the energy to be radiated, as in the case of the prior art documents, but also to modulate the desired pulse along time with predefined characteristics.

In particular, the modulation is performed by using the parameters $\Delta\tau_{\mathbf{x}}$, $\Delta\tau_{\mathbf{y}}$, **T, $t_{rise}$, $t_{fall}$, $L^1_{tx}$, $L^2_{tx}$** determined by the proposed the algorithm; the modulation not only takes into account the non-idealities of the components, but exploits them to modulate in the desired way. A high-voltage Power Modulator is certainly a complex device that must be suitably designed and at least provides high realization costs. Moreover, considering the architectures of the prior art documents, there will be a modification of the pulse as modulator by the Power Modulator due to the non-ideality of the switch, the Blumlein and the antenna. The prior art documents do not take into account these effects, nor they show how these influence the output modulated waveform. More in detail, the fact that the switch has a non-vanishing closing and opening time will surely influence the form of the output pulse, and the prior art has no means to control this phenomenon. Moreover, the differences between different channels of the array are not taking into account, limiting the treatment to the assumption that all the channels behave in the same way.

Further, in the architectures of the prior art documents, the possibility of having a Blumlein with two transmission line segments of different length $L^1_{tx}$, $L^2_{tx}$ so as to have different modulations of the output pulse, is not mentioned.

Bibliography

[1] G. Franceschetti, James Tatoian, and George Gibbs, "Timed Array in a Nutshell'; IEEE Trans. On Antennas and Prop., vol. 53, n. 12, December 2005.

In the foregoing, aspects of the invention have been described and variations of the invention have been suggested, but it is to be understood that those skilled in the art will be able to modify and change the invention, without falling outside the scope of protection as defined by the attached claims.

**Claims**

1. Method for the determination of the parameters of electro-magnetic pulses to be sent to a transmission modules array of the type timed array having directions of extension x and/or y corresponding to the traditional Cartesian coordinate, each comprising at least a switch with opening time $t_{open}$, closing time $t_{close}$ and permanence time T of the switch in the close position, and relevant variability ranges, a UWB antenna with effective height $h(\theta,\varphi)$, an electric power generator, in order to irradiate altogether from said array a pre-defined electro-magnetic pulse defined by the following pulse parameters:

   • beam width of the pre-defined pulse for every direction $\theta$, $\varphi$ of irradiation;
   • bandwidth of the pre-defined pulse $\Delta f \in [f_{min}, f_{max}]$;
   • scanning region as defined by the variation of the angles $\theta$, $\varphi$, $\Delta\theta \in [\theta_{min}, \theta_{max}]$, $\Delta\varphi \in [\varphi_{min}, \varphi_{max}]$;

   wherein the pulses to be sent to the various modules have delays $\Delta\tau_x$ e $\Delta\tau_y$ in the two directions x and y,
   The method being **characterised in that**:

   - a numerical model is utilized which describes the different elements of each module of the modules array, as a function of parameters $\Delta\tau_{\mathbf{x}}$, $\Delta\tau_{\mathbf{y}}$, **T, $t_{open}$, $t_{close}$**, which are vectors whose components correspond to the various modules of the system, the numerical model providing the total transfer function g($\Delta\tau_{\mathbf{x}}$, $\Delta\tau_{\mathbf{y}}$, **T, $t_{open}$, $t_{close}$**) of said modules array,
   - said transfer function is inserted into the following functional:

$$\Phi = \left\| g(\Delta\tau_x, \Delta\tau_y, T, t_{open}, t_{close})\text{-}G_0 \right\|^2$$

Wherein $G_0$ is a target function relevant to said pre-determined electro-magnetic pulse,
- said functional being minimized by an optimization algorithm, to determine the values of the delays $\Delta\tau_x$, $\Delta\tau_y$ and the values $T$, $t_{open}$, $t_{close}$ for each module and each irradiation direction $\theta, \varphi$.

2. Method according to claim 1, **characterized in that**, once said values $\Delta\tau_x$, $\Delta\tau_y$, **T**, $t_{open}$, $t_{close}$ are obtained, a sensibility analysis is performed to the end of verifying the acceptable jitter values for each single module of said modules array.

3. Method according to claim 1 or 2, **characterized in that** each utilized module comprises at least a modified Blumlein PFN, comprising two transmission lines and a resistance in series between the two transmission lines and wherein:

- said at least a switch is at least a photoconductive switch comprising a generator of laser pulses of duration T, with rise time $t_{rise}$ and fall time $t_{fall}$;
- the resistance (R) is constituted or replaced by a UWB antenna;
- the two transmission lines presents respective lengths $L^1_{tx}$ e $L^2_{tx}$;
$L^2_{tx}$;

the functional to be minimized being:

$$\Phi = \left\| g(\Delta\tau_x, \Delta\tau_y, T, t_{rise}, t_{fall}, L^1_{tx}, L^2_{tx})\text{-}G_0 \right\|^2$$

wherein $L^1_{tx}$, $L^2_{tx}$, $t_{rise}$, $t_{fall}$ are vectors whose components correspond to the various modules of the system and the parameters $t_{rise}$ and $t_{fall}$ are connected respectively to the parameters $t_{close}$ and $t_{open}$ by a functional relation.

4. Method according to any claim 1 to 3, **characterised in that** between both input and output parameters a priority scale is set, which is introduced by a weight vector.

5. Method according to any claim 1 to 4, **characterised in that** said modified Blumlein comprises a further resistance in the place of the open circuit of the classical Blumlein, and **in that** the function $g$ depends also on the value of said further resistance, whose value is therefore optimised.

6. Method for irradiating an electro-magnetic pulse by an irradiation modules array, each module comprising at least a switch, a UWB antenna, a power generator, **characterised in that** it executes the following steps:

- calculating:

• time delays between pulses to be fed to each antenna of each module of the modules array;
• duration T, opening time $t_{open}$ and closing time $t_{close}$ of said at least a switch for each module; according to the method of any claim 1 to 5;

- generating the single pulses within each module according to a time sequence corresponding to the calculated time delays; and
- sending said pulses to the corresponding UWB antenna.

7. Apparatus for the irradiation of a pre-determined electro-magnetic pulse having pre-defined pulse parameters by a transmission modules array of the type timed array having two directions of extension x and/or y, each module irradiating a module pulse according to a pre-defined time sequence between the modules, wherein each transmission module of said modules array comprises at least a Blumlein PFN, comprising two transmission lines, a resistance and at least a switch, and at least a power modulator, and wherein:

- said at least a switch is at least a photo-conductive switch comprising a generator of laser pulses of duration T, with rise time $t_{rise}$ and fall time $t_{fall}$;
- the resistance (R) is constituted or replaced by a UWB antenna;
- said two transmission lines of the Blumlein PFN and said UWB antenna are adapted so as to approximate a TEM mode;

The apparatus being **characterized in that**:

- the Blumlein PFN is modified in such a way that the two transmission lines present respective lengths $L^1_{tx}$ and $L^2_{tx}$ which can be independently determined;
- said at least a power modulator is constituted by the same modified Blumlein PFN, said at least a switch, and an electronic unit for controlling said pre-determined sequence module pulses,

Said electronic unit for controlling possessing the values of said pulse parameters for each module and for each single irradiation direction, as calculated by using the method according to any claim 3,4,5.

8. Apparatus according to claim 7, **characterised in that** said UWB antenna has an input impedance that is substantially real and constant within the frequencies of the apparatus transmission bandwidth.

9. Apparatus according to any claim 7 or 8, **characterised in that** said antenna is chosen so as to guarantee a smooth transition between the transmission line and the antenna on one side, and the free space on the other side.

Fig. 1

Fig. 2

Fig. 3

Fig. 4

Fig. 5

Fig. 6

$$\Delta\tau = \frac{d\,sin(\sigma)}{c}$$

Fig. 7

$$\Delta\tau = \frac{d\,sin(\sigma)}{c}$$

Fig. 8

EP 2 555 324 A2

Details of the irradiated pulse
• Beam width
• Band
• Scanning area

☐ Input

◼ Output

•Effective height
•Technology limits

**Beamforming**

• Timing
• Duration Rise Time e Fall Time
  of the laser pulses
• Transmission line lengths

**Sensitivity analisis**

Tolerance

Fig. 9

Input → Photoconductive switch → Pulses generator → Antenna → Output

Fig. 10

25

Fig. 11

Fig. 12

Fig.13

Fig. 19

Fig. 15

(a)

(b)

Fig. 16

Fig. 17

Fig. 18

(a)

Pulses as a function of the lenghts of Blumleins

(b)

Fig.14

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6061034 A

**Non-patent literature cited in the description**

- Ultra-Wideband Source Using Gallium Arsenide Photoconductive semiconductor Switches. **JON S.H. SCHOENBERG et al.** IEEE TRANSACTION ON PLASMA SCIENCE. IEEE SERVICE CENTER, 01 April 1997, vol. 25
- A Novel Antenna for Transient Applications in the Frequency Band 300 MHz - 3 GHz: The Valentine Antenna. **J-C DIOT.** IEEE TRANSACTION ON ANTANNAS AND PROPAGATION. IEEE SERVICE CENTER, 01 March 2007, vol. 55, 987-990

- **G. FRANCESCHETTI ; JAMES TATOIAN ; GEORGE GIBBS.** Timed Array in a Nutshell. *IEEE Trans. On Antennas and Prop.,* December 2005, vol. 53 (12